# EUROPEAN PATENT SPECIFICATION

(11) **EP 1 538 241 B1**
(45) Date of publication and mention of the grant of the patent: **17.12.2008**
(21) Application number: 04023416.3
(22) Date of filing: 01.10.2004
(51) Int. Cl.: C30B 9/00, C30B 29/40

(54) **Group III nitride crystal, method of its manufacturing, and equipment for manufacturing group III nitride crystal**
Kristall eines Nitrids der Gruppe III, Verfahren zur dessen Herstellung und Vorrichtung zur Herstellung eines Kristalls eines Nitrids der Gruppe III
Cristal de nitrure de groupe III, procédé de fabrication de ce cristal, et appareil de fabrication de cristal de nitrure de groupe III

(30) Priority: 31.10.2003 JP 2003373025; 01.07.2004 JP 2004195666
(43) Date of publication of application: 08.06.2005
(60) Divisional application: 08003737.7
(73) Proprietor: Sumitomo Electric Industries, Ltd., Osaka-shi, Osaka 541-0041 (JP)
(72) Inventor: Hirota, Ryu Itami Works, Itami-shi Hyogo (JP); Nakahata, Seiji Itami Works, Itami-shi Hyogo (JP)
(74) Representative: Grünecker, Kinkeldey, Stockmair & Schwanhäusser Anwaltssozietät

(56) References cited:
- WO-A2-02/101120
- JP-A- 2001 338 887
- US-A1- 2003 164 138
- AOKI M ET AL: "Conditions for seeded growth of GaN crystals by the Na flux method" MATERIALS LETTERS, NORTH HOLLAND PUBLISHING COMPANY. AMSTERDAM, NL, vol. 56, no. 5, November 2002 (2002-11), pages 660-664, XP004388914 ISSN: 0167-577X
- AOKI M ET AL: "Growth of GaN single crystals from a Na-Ga melt at 750<o>C and 5MPa of N2" JOURNAL OF CRYSTAL GROWTH, NORTH-HOLLAND PUBLISHING CO. AMSTERDAM, NL, vol. 218, no. 1, 1 September 2000 (2000-09-01), pages 7-12, XP004214603 ISSN: 0022-0248
- YANO M ET AL: "Growth of nitride crystals, BN, AlN and GaN by using a Na flux" DIAMOND AND RELATED MATERIALS, ELSEVIER SCIENCE PUBLISHERS, AMSTERDAM, NL, vol. 9, no. 3-6, April 2000 (2000-04), pages 512-515, XP004199807 ISSN: 0925-9635

## Description

### BACKGROUND OF THE INVENTION

### Technical Field

The present invention relates to Group III nitride crystals, to methods of their manufacture, and to equipment for manufacturing crystals of Group III nitrogen compounds; in particular the invention relates to Group III nitride crystals for which the rate of crystal growth into the Group III nitride crystals is high, to methods of their manufacture, and to equipment for manufacturing the Group III nitride crystals.

### Description of the Background Art

The decomposition temperature of Group III nitrides such as GaN at normal pressure is lower than their melting temperature, which makes it difficult to produce crystals of the Group III nitrides by molten-growth techniques at normal pressure. For that reason, to date a high-N₂-pressure melt technique has been employed, in which under a high temperature of approximately 1500°C and high nitrogen (N₂) pressure of some 1 GPa to 2 GPa, GaN crystals are grown by dissolving nitrogen into a Ga melt.

JP 2001-338887 describes a method and apparatus for growing a III-V nitride semiconductor. A cooling means is attached to the bottom of the vessel to help create a temperature gradient from the front face of the group III melt to the bottom of the vessel in order to increase crystal growth.

US2003/0164138 describes a method and apparatus for growing a group-III nitride crystal. The crystal growth apparatus may include two heating devices provided next to the reaction vessel. The first heating device functions to control the temperature of the group-III nitride inside of the melt or, the surface of the melt to a temperature which allows crystal growth. The second heating device functions to control the temperature of a part above the surface of the melt. Specifically, the temperature above the surface of the melt is raised by the second heating device to effectively reduce the evaporation of the alkaline metal from the melt.

WO 02/101120 describes a method for preparing a gallium-containing nitride crystal. The gallium-containing nitride may additionally include one donor and/or at least one acceptor to alter the optical and electrical properties of the substrate. Preferably the donor dopants are selected from the group consisting of Si and O. Typically the concentrations of these dopants range from 10¹⁷ to 10²¹/cm³.

In recent years, as the prevailing technique enabling such crystal to be grown under more congenial conditions, a sodium (Na) flux method in which crystal growth is carried out by dissolving nitrogen in a Ga-Na melt under a temperature of some 600°C to 800°C and a nitrogen-gas pressure of some 5 MPa has been proposed (for example, in the specification for U.S. Pat. No. 5,868,837, and in Japanese Unexamined Pat. App. Pub. Nos. 2001-58900, 2001-102316, 2001-64098, 2001-128587).

In technical document "Material Letters, North Holland Publishing Company, Amsterdam, NL, vol. 56, no. 5, November 2002, XP004388914" by Aoki M et al, conditions for seeded growth of GaN crystals by the Na flux method were investigated. At 850°C and 2Mpa of N₂, the maximum growth rate was in the C direction and GaN single crystals having a thickness of 1.0mm were obtained.

Nevertheless, in the foregoing conventional sodium flux method, dissolution and diffusion of nitrogen into the Ga-Na melt is slow, and thus the crystal growth rate for the GaN crystal is low. Under the circumstances, there is a strongly felt need in the industry for the development of a method for manufacturing Group III nitride crystals in which the rate at which the crystals grow is high.

### SUMMARY OF THE INVENTION

An object of the present invention, in view of the circumstances noted above, is to make available Group III nitride crystals whose crystal growth rate is extensive, a method of their manufacture, and equipment for manufacturing such Group III nitride crystals.

The present invention achieves its object by providing a method of manufacturing Group III nitride crystal comprising the steps set out in claim 1, and manufacturing equipment for carrying out the method comprising the features of claim 11.

The present invention is a method of manufacturing Group III nitride crystal, including a melt-formation step, within a reaction vessel, of forming around a seed crystal a melt containing at least a Group III element and a catalyst, and a crystal-growth step of supplying a nitrogen-containing substance to the melt to grow a Group III nitride crystal onto the seed crystal, with the Group-III-nitride-crystal manufacturing method being characterized in that in the crystal-growth step temperature is controlled so that the temperature of the melt lowers from the interface between the melt and the nitrogen-containing substance, through to the interface between the melt and the seed crystal or to the interface between the melt and the Group III nitride crystal having grown onto the seed crystal.

Herein, in a Group-III-nitride-crystal manufacturing method involving the present invention, in the crystal-growth step temperature is controlled so that furthermore the relationship among the temperature *T_{N}* at the interface between the melt and the nitrogen-containing substance, the temperature *T_{C}* at the interface between the melt and the seed crystal or at the interface between the melt and the Group III nitride crystal having grown onto the seed crystal, and the temperature *T_{O}* at which the nitrogen-containing substance having dissolved within the melt deposits as the Group III nitride crystal will be *T_{N}* > *T_{O}* ≥ *T_{C}*, and so that between *T_{N}* and *T_{C}* the difference in temperature *T_{N} - T_{C}* will be from 10°C to 300°C.

In a preferred embodiment, the seed crystal can be locally cooled.

In another preferred embodiment, graphite can be utilized for a heater and an insulating member provided together with the reaction vessel in an outer container. A step of pretreating the reaction vessel by heating it to remove moisture from the vessel can be further included. A step, following the melt-formation step, of removing a surface-oxidation layer from the melt prior to the crystal-growth step can be further included.

In a Group-III-nitride-crystal manufacturing method involving the invention in a further aspect a Group-III-nitride-crystal substrate can be utilized as the seed crystal. An option in the present invention in the foregoing aspects is to have the melt-formation step be a step of forming around both the seed crystal and a nitrogen-containing substance within the reaction vessel a melt containing at least a Group III element and a catalyst, and to have the crystal-growth step be a step in which by the nitrogen-containing substance dissolving in the melt the Group III nitride crystal is grown onto the seed crystal. And another option is to have the nitrogen-containing substance be a Group III nitride obtained by irradiating with a nitrogen plasma the surface of a molten liquid containing at least a Group III element.

In a Group-III-nitride-crystal manufacturing method involving the invention in still further aspects, by furthermore adding silicon as a dopant to the melt, a concentration of silicon within the Group III nitride crystal can be adjusted; and by furthermore adding an oxygen-containing substance as a dopant either to the melt or to the nitrogen-containing substance, a concentration of oxygen within the Group III nitride crystal can be adjusted.

The present invention is in other aspects a Group III nitride crystal manufactured by a Group-III-nitride-crystal manufacturing method as set forth in the foregoing-being either a Group III nitride crystal in which the silicon concentration within the Group III nitride crystal exceeds 1 × 10¹⁷ atoms/cm³, or in which the concentration is not more than that.

The present invention in a related aspect is a Group III nitride crystal manufactured, in a Group-III-nitride-crystal manufacturing method as set forth in the foregoing, by furthermore adding an oxygen-containing substance as a dopant either to the melt or to the nitrogen-containing substance to adjust a concentration of oxygen within the Group III nitride crystal, therein being a Group III nitride crystal in which the oxygen concentration within the Group III nitride crystal exceeds 1 × 10¹⁷ atoms/cm³.

The present invention is in a further aspect a Group III nitride crystal manufactured by a Group-III-nitride-crystal manufacturing method as set forth in the foregoing-being a Group III nitride crystal in which the oxygen concentration within the Group III nitride crystal is 1 × 10¹⁷ atoms/cm³ or less.

The present invention also presents a Group-III-nitride-crystal manufacturing equipment having a reaction vessel that can accommodate around a seed crystal a melt containing at least a Group III element and a catalyst, a cooling member for locally cooling the seed crystal and a low-temperature heater and a high-temperature heater surrounding the reaction vessel in order to create a temperature gradient.

The present invention affords Group III nitride crystals and methods of their manufacture, wherein the crystal growth rate is extensive, as well as equipment for manufacturing such Group III nitride crystals.

From the following detailed description in conjunction with the accompanying drawings, the foregoing and other objects, features, aspects and advantages of the present invention will become readily apparent to those skilled in the art.

### BRIEF DESCRIPTION OF THE DRAWINGS

Fig. 1 is schematic diagrams illustrating one method involving the present invention of manufacturing Group III nitride crystal. Fig. 1A is a schematic diagram representing manufacturing equipment; Fig. 1B is a schematic diagram illustrating a melt-formation step; and Fig. 1C is a schematic diagram illustrating a crystal-growth step.
Fig. 2 is schematic diagrams illustrating another Group-III-nitride-crystal manufacturing method involving the present invention. Fig. 2A is a schematic diagram illustrating a melt-formation step; Fig. 2B is a schematic diagram illustrating a manufacturing step in which a surface oxidation layer is removed from the melt; and Fig. 2C is a schematic diagram illustrating a crystal-growth step.
Fig. 3 is a schematic diagram illustrating yet another Group-III-nitride-crystal manufacturing method involving the present invention.
Fig. 4 is a schematic diagram illustrating still another Group-III-nitride-crystal manufacturing method involving the present invention.

### DETAILED DESCRIPTION OF THE INVENTION

Modes of embodying the present invention will be specifically described in the following. It should be understood that in the drawings accompanying the present description, identical reference marks are meant to indicate either identical or equivalent parts.

### Embodiment 1

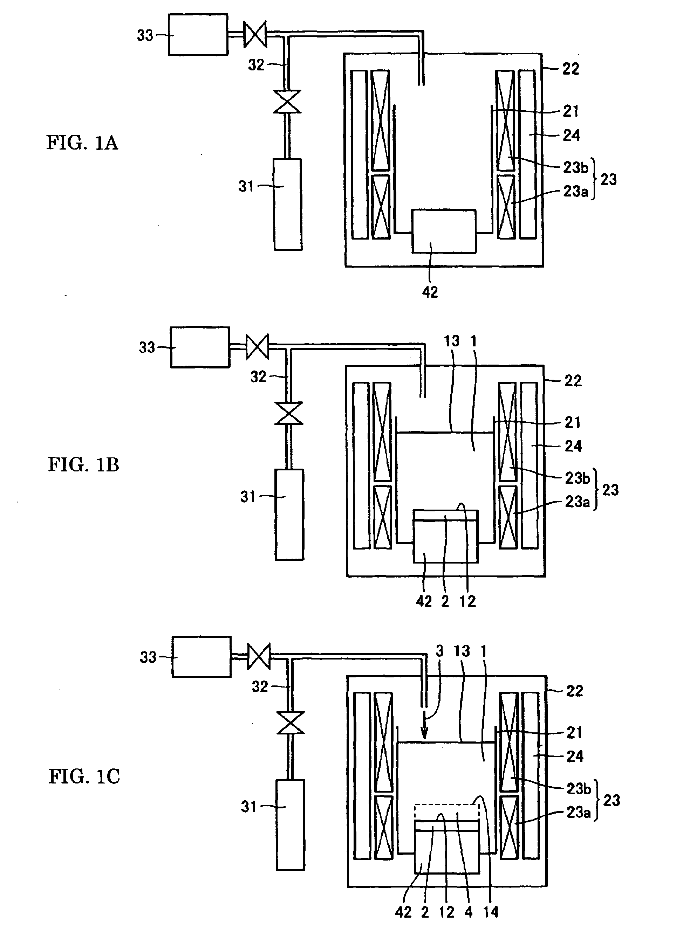

One method, involving the present invention, of manufacturing a Group III nitride crystal is illustrated in Fig. 1. In the manufacturing equipment utilized in the manufacturing method, at least a reaction vessel 21, heaters 23 (low-temperature heater 23a and high-temperature heater 23b) for heating the reaction vessel, and an insulating member 24 are housed in an outer container 22, with respect to which a nitrogen-containing-substance supply apparatus 31 and nitrogen-containing-substance supply line 32 for supplying a nitrogen-containing substance to the reaction vessel 21 are arranged.

This one Group-III nitride crystal manufacturing method involving the present invention includes: with reference to Fig. 1B, a melt-formation step, within the reaction vessel 21, of forming around a seed crystal 2 a melt 1 containing at least a Group III element and a catalyst; and, with reference to Fig. 1C, a crystal-growth step of supplying a nitrogen-containing substance 3 to the melt 1 to grow a Group III nitride crystal 4 onto the seed crystal 2. Furthermore the method controls temperature so that in the crystal-formation step, the temperature of the melt 1 lowers from the interface 13 between the melt 1 and the nitrogen-containing substance 3, through to the interface 12 between the melt 1 and the seed crystal 2 or to the interface 14 between the melt 1 and the Group III nitride crystal 4 having grown onto the seed crystal 2.

Because the solubility, into the melt, of the nitrogen within the nitrogen-containing substance increases with elevation in temperature, setting up a temperature gradient in the melt in which the temperature lowers from the melt interface with the nitrogen-containing substance through to the melt interface with the seed crystal or with the Group III nitride crystal having grown onto the seed crystal produces a nitrogen concentration gradient in which the concentration of the nitrogen dissolved in the melt lowers from the interface with the nitrogen-containing substance through to interface with the seed crystal or with the Group III nitride crystal having grown atop the seed crystal. By the agency of this nitrogen concentration gradient nitrogen is supplied continuously diffused to the melt interface with the seed crystal or with the Group III nitride crystal having grown atop the seed crystal, therefore promoting growth of the Group III nitride crystal along the top of the seed crystal.

Herein, in the melt-formation step illustrated in Fig. 1B, either of two methods may be utilized: 1) a method in which a Group III element and a catalyst are entered into and heated within the reaction vessel 21 to produce the melt 1 and thereafter the seed crystal 2 is introduced into the melt 1; or 2) a method in which by entering a Group III element, a catalyst, and the seed crystal 2 into the reaction vessel 21 and heating these items, a melt 1 containing the Group III element and the catalyst surrounding the seed crystal 2 is formed.

The Group III element contained in the melt may be, to cite preferable examples, Al, Ga or In. Likewise, the catalyst contained in the melt fuses with the Group III element and promotes reaction between the Group III element and nitrogen, and may be, to cite preferable examples, an alkali metal or a transition metal. In implementations in which Ga is used as the. Group III element, Na or the like being an alkali metal is preferably utilized as the catalyst; in implementations in which Al is used as the Group III element, Fe, Mn, Cr or the like being a transition metal is preferably utilized as the catalyst. And in the melt the ratio between the mol % of the Group III element and the mol % of the catalyst is not particularly limited, but preferably is Group III element: catalyst - 5 : 95 to 90 : 10. Too low a mol % of the Group III element in the melt makes the supply of the Group III element fall short, stunting growth of Group III nitride crystal, while too low a mol % of the catalyst lessens the amount of nitrogen that dissolves into the melt, which makes the supply of nitrogen fall short, stunting growth of Group III nitride crystal. From these perspectives, in the melt the ratio between the mol % of the Group III element and the mol % of the catalyst preferably is Group III element: catalyst - 10 : 90 to 75 : 25.

Then in the crystal-growth step illustrated in Fig. 1C, it is sufficient that the nitrogen-containing substance that is supplied to the melt is one that will dissolve into the melt and serve as a source for growing Group III nitride crystal; in addition to nitrogen-containing gases such as nitrogen gas and ammonia gas, such substances include NaN₃ and Group III nitrides. The present embodiment is adapted to supplying nitrogen-containing gas as the nitrogen-containing substance. And the pressure for supplying the nitrogen-containing gas is preferably 0.1 MPa to 10.0 MPa. If the pressure of the nitrogen-containing gas is less than 0.1 MPa, nitrogen is not adequately supplied within the melt, on account of which the growth of Group III nitride crystal is stunted. On the other hand, to have the pressure of the nitrogen-containing gas exceed 10.0 MPa would complicate the reaction apparatus. From these perspectives, the pressure of the nitrogen-containing gas more preferably is 1.0 MPa to 5.0 MPa.

Also, in the crystal-growth step illustrated in Fig. 1C there are no particular restrictions on the method for controlling temperature so that the temperature of the melt 1 lowers from the interface 13 between the melt 1 and the nitrogen-containing substance 3, through to the interface 12 between the melt 1 and the seed crystal 2 or to the interface 14 between the melt 1 and the Group III nitride crystal 4 having grown onto the seed crystal 2; thus controlling temperature may, for example, be accomplished utilizing two types of heaters, the low-temperature heater 23a and the high-temperature heater 23b, to vary the heating temperature locally.

In the method according to the present embodiment of manufacturing Group III nitride crystals, in the instance of the crystal-growth step illustrated in Fig. 1C, temperature is controlled so that furthermore the relationship among the temperature *T_{N}* at the interface 13 between the melt 1 and the nitrogen-containing substance 3, the temperature *T_{C}* at the interface 12 between the melt 1 and the seed crystal 2 or at the interface 14 between the melt 1 and the Group III nitride crystal 4 having grown onto the seed crystal 2, and the temperature *T_{O}* at which the nitrogen-containing substance 3 having dissolved within the melt 1 deposits as the Group III nitride crystal 4 will be *T_{N} > T_{O}* ≥ *T_{C}*, and so that between *T_{N}* and *T_{C}* the difference in temperature *T_{N} - T_{C}* will be from 10°C to 300°C. Here, the foregoing temperature measurements are made by thermocouples inserted into protective alumina tubes in the applicable locations.

Having *T_{N}* > *T_{O}* stops Group III nitride crystal from depositing in the vicinity of the interface 13 between the melt 1 and the nitrogen-containing substance 3, therefore allowing nitrogen to diffuse sufficiently into the deeper reaches of the melt. Furthermore, having *T_{O}* ≥ *T_{C}* makes it possible to grow Group III nitride crystal onto the seed crystal efficiently. Accordingly, having *T_{N} > T_{O}* ≥ *T_{C}* is the more conducive of the growth of Group III nitride crystal atop the seed crystal. In this respect, although the larger the difference *T_{N}- T_{C}* is the more can the growth of Group III nitride crystal be promoted, the larger *T_{N}- T_{C}* is the greater will be the likelihood that the Group III nitride crystal will deposit elsewhere than on the seed crystal within the melt.

Again, temperature is controlled so that *T_{N} - T_{C}* will be from 10°C to 300°C. *T_{N} - T_{C}* being less than 10°C diminishes the temperature gradient in the melt from the interface with the nitrogen-containing substance through to the interface with the seed crystal or with the Group III nitride crystal having grown onto the seed crystal, which decreases the supply of nitrogen into the crystal growth region, diminishing the crystal growth rate. On the other hand, if *T_{N} - T_{C}* exceeds 300°C, excess nitrogen is supplied into the melt, increasing the likelihood that the Group III nitride crystal will deposit elsewhere than on the seed crystal. From these perspectives, the lower limit of *T_{N}- T_{C}* preferably is not less than 50°C, with not less than 100°C being further preferable, while the upper limit of *T_{N} - T_{C}* preferably is not more 250°C, with not more than 200°C being further preferable.

In respect of the controlled temperature values, *T_{N}* and *T_{C}* can be set to temperatures suited to the Group III element and catalyst utilized for the Group III nitride crystal. For example, in an implementation in which as the Group III element Ga or Al, and as the catalyst the alkali metal Na are utilized to grow either GaN crystal or A1N crystal as Group III nitride crystals, *T_{N}* preferably is set to between 700°C and 1000°C, and *T_{C}* to between 500°C and 800°C. Likewise, in an implementation in which as the Group III metal Al, and as the catalyst a metal such as Fe, Mn or Cr are utilized to grow A1N crystal as a Group III nitride crystal, *T_{N}* preferably is set to between 900°C and 1600°C, and *T_{C}* to between 700°C and 1400°C.

In the method according to the present embodiment of manufacturing Group III nitride crystals, in the instance of the crystal-growth step illustrated in Fig. 1C, furthermore it is preferable that the seed crystal 2 be locally cooled. Locally cooling the seed crystal further lowers the temperature at the interface 12 between the melt 1 and the seed crystal 2 or at the interface 14 between the melt 1 and the Group III nitride crystal 4 having grown onto the seed crystal 2, making it the more possible to promote growth of the Group III nitride crystal.

In this respect, while there are no particular restrictions on the method for locally cooling the seed crystal, preferably, as illustrated in Fig. 1C a cooling element 42 is contacted on the seed crystal 2 to dispose of heat. A material of high thermal conductivity or a material of high transparency to infrared rays is preferably utilized as the cooling element. Highly thermoconductive materials, such as various metals and A1N crystal, can dispose of heat to the exterior of the reaction vessel by thermally conducting heat from the seed crystal. Sapphire, quartz and similar materials highly transparent to infrared rays can dispose of heat to the exterior of the reaction vessel by thermal radiating heat from the seed crystal. Utilizing a highly infrared-transparent material such as sapphire as the cooling element is especially preferable. Utilizing a sapphire rod as the cooling element makes it possible to bring the temperature *T_{C}* at the interface between the seed crystal and the melt down to a temperature 300°C or more lower than the temperature *T_{N}* at the interface between the nitrogen-containing substance and the melt.

Although in Fig. 1 the cooling element 42 for cooling the seed crystal 2 is shown provided on the reaction vessel 21, the cooling element 42 can be provided on the exterior of the reaction vessel 21 so as to reach to the outer container 22. Making it so that the cooling element contacts the outer container 22 enables disposing of the seed-crystal heat directly to the outer container 22 exterior, thereby producing greater effectiveness with which the seed crystal is cooled.

While there are no particular restrictions on what the materials of the reaction vessel and the outer container that accommodates the reaction vessel utilized in the present embodiment are, from the perspectives of high resistance to heat and minimal in-mixing of impurities, materials such as alumina, pyrolytic BN, and platinum are preferable for the reaction vessel, and alloys such as stainless steel and Inconel^{™} are preferable for the outer container. And although there are no particular restrictions on what the materials of the heaters and the insulating member are, from the same perspectives as just noted, graphite is preferable.

### Embodiment 2

A separate method, involving the present invention, of manufacturing a Group III nitride crystal utilizes the manufacturing equipment that, as illustrated in Fig. 1, includes inside the outer container 22 at least the reaction vessel 21, which has an opening, the heaters 23, and the insulating member 24, with the heaters 23 and the insulating member 24 being constituted from graphite, wherein the method includes: as indicated in Fig. 1B, a melt-formation step, within the reaction vessel 21, of forming around a seed crystal 2 a melt 1 containing at least one or more elements selected from the group consisting of Group III elements, alkali metals, and transition metals; and as indicated in Fig. 1C, a crystal-growth step of supplying a nitrogen-containing substance 3 to the melt 1 to grow a Group III nitride crystal 4 onto the seed crystal 2. Utilizing a small-surface-area material like graphite in the heaters and insulating member contributes to controlling the oxygen and/or water vapor that are generated mainly through the heaters and insulating member from dissolving in the melt inside the reaction vessel when the temperature is raised, which promotes the dissolution of nitrogen into the melt to spur growth of the Group III nitride crystal. From these perspectives, the purer graphites are the more preferable; for example, a graphite whose impurity concentration is 10 ppm is desirable.

### Embodiment 3

A separate method, involving the present invention, of manufacturing a Group III nitride crystal includes, with reference to Fig. 1: a step as indicated in Fig. 1A of pretreating the reaction vessel 21 by heating it to remove moisture; as indicated in Fig. 1B, a melt-formation step, within the reaction vessel 21 from which moisture has been eliminated, of forming around a seed crystal 2 a melt 1 containing at least one or more elements selected from the group consisting of Group III elements, alkali metals, and transition metals; and as indicated in Fig. 1C, a crystal-growth step of supplying a nitrogen-containing substance 3 to the melt 1 to grow a Group III nitride crystal 4 onto the seed crystal 2. Pretreating the reaction vessel 21 by heating it to remove moisture reduces the dissolution of water vapor into the melt 1, promoting the dissolution of nitrogen into the melt 1 to spur growth of the Group III nitride crystal. While in this aspect there are no particular restrictions on the conditions under which the heating process is performed as long as the process can eliminate moisture from the reaction vessel, preferably the vessel is treated by heating it 1 hour or more at 100°C or more while drawing a vacuum on it to 100 Pa or less.

### Embodiment 4

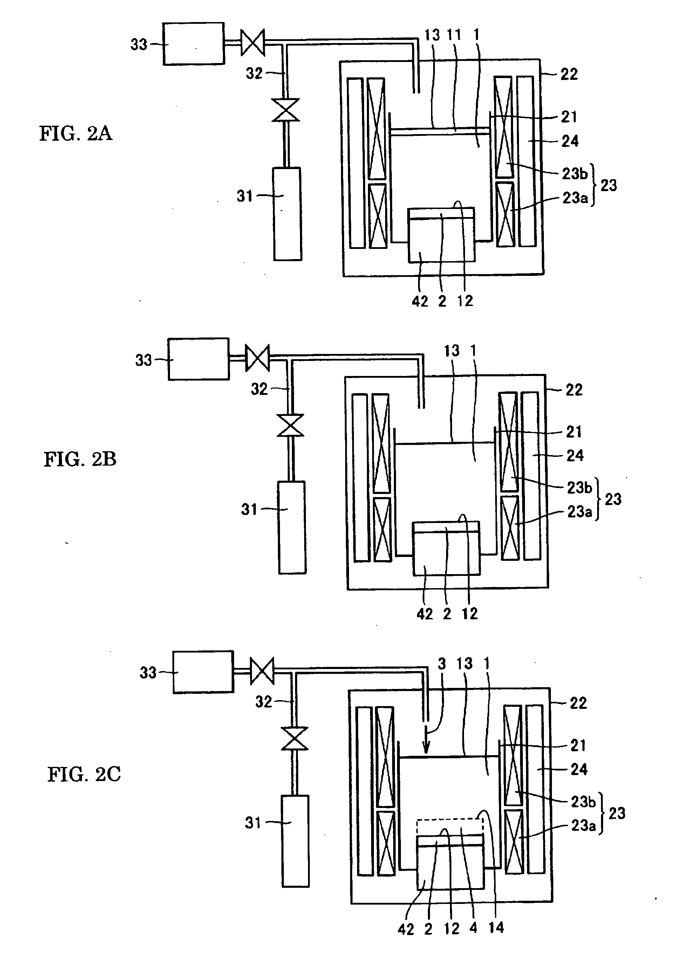

In Fig. 2 another Group III nitride-crystal manufacturing method involving the present invention is represented. Manufacturing equipment that is similar to the manufacturing equipment in Fig. 1 can be utilized in this manufacturing method. This other Group III nitride-crystal manufacturing method involving the present invention includes: with reference to Fig. 2A, a melt-formation step, within the reaction vessel 21, of forming around a seed crystal 2 a melt 1 containing at least one or more elements selected from the group consisting of Group III elements, and as a catalyst, alkali metals and transition metals; with reference to Figs. 2a and 2B, a step of removing a surface oxidation layer from the melt 1; and with reference to Fig. 2C, a crystal-growth step of supplying a nitrogen-containing substance 3 to the melt 1 to grow a Group III nitride crystal 4 onto the seed crystal 2. Removing the surface oxidation layer on the melt 1 promotes the dissolution of nitrogen into the melt 1 to spur growth of the Group III nitride crystal. In this respect, because in addition to oxides of the melt, impurities such as B and Al, which derive from the material that the reaction vessel is made of, are taken into the surface oxidation layer, by removing the surface oxidation layer better-quality Group III nitride crystal can be obtained. Although there are no particular limitations on the method of removing the surface oxidation layer, preferable methods that may be given include aspirating the surface oxidation layer off the melt. Therein, given that the thickness of the surface oxidation layer on the melt, based on an observation made through a cross section of a cooled melt in which no special measures were taken to prevent oxidation, was even at its thickest no more than 10 % of the height of the melt, by removing from the surface of the melt a surface layer of at least 10 % with respect to the height of the melt the surface oxidation layer can be eliminated.

It will be appreciated that in the foregoing Embodiments 2 through 4, in occasioning the crystal-growth step, setting up a temperature gradient in the melt in the same manner as in Embodiment 1 further promotes dissolution of nitrogen into the melt to give further impetus to the growth of the Group III nitride crystal.

### Embodiment 5

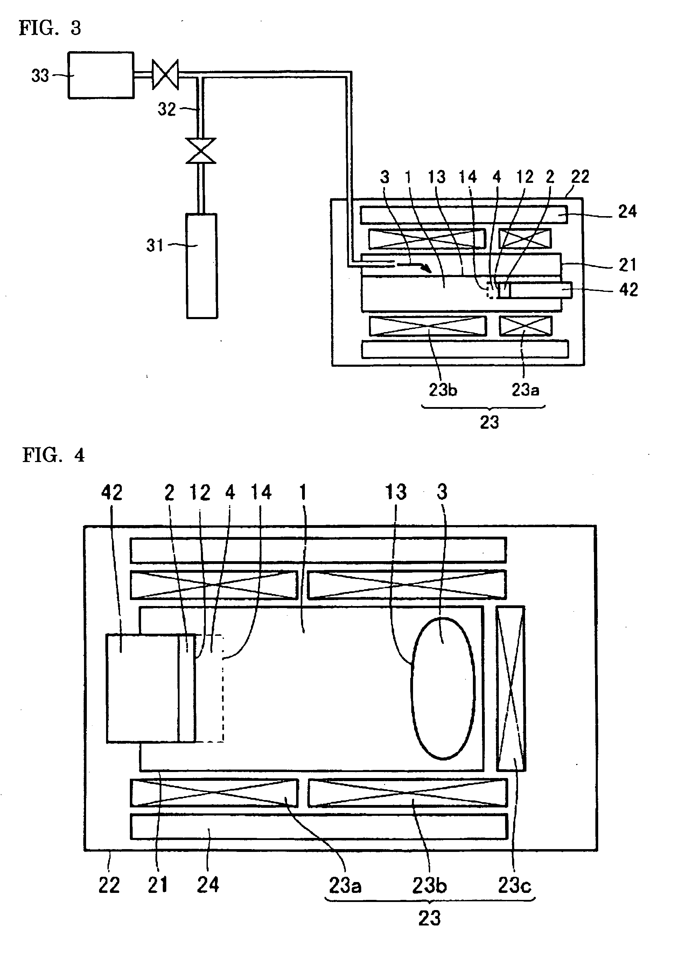

In Fig. 3 yet another Group III nitride-crystal manufacturing method involving the present invention is represented. In the manufacturing equipment utilized in this manufacturing method, likewise as with the manufacturing equipment illustrated in Figs. 1 and 2, at least the reaction vessel 21, the heaters 23 (low-temperature heater 23a and high-temperature heater 23b) for heating the reaction vessel, and the insulating member 24 are housed in the outer container 22, with respect to which the nitrogen-containing-substance supply apparatus 31 and nitrogen-containing-substance supply line 32 for supplying a nitrogen-containing substance to the reaction vessel 21 are arranged.

In the manufacturing equipment illustrated in Figs. 1 and 2, however, the seed crystal 2 is disposed on the bottom part of the reaction vessel 21 with the principal, crystal-growing face directed up, and the low-temperature heater 23a and high-temperature heater 23b are installed so as to set up a top-to-bottom oriented temperature gradient in the melt 1 inside the reaction vessel 21, wherein the Group III nitride crystal 4 is grown in the upward direction of the seed crystal 2. In contrast to this configuration, in the manufacturing equipment illustrated in Fig. 3, the seed crystal 2 is disposed in a side portion of the reaction vessel 21 with the principal, crystal-growing face directed sideways, and the low-temperature heater 23a and high-temperature heater 23b are installed so as to set up a sideways oriented temperature gradient in the melt 1 inside the reaction vessel 21, wherein the Group III nitride crystal 4 is grown in a lateral direction of the seed crystal 2.

In the present embodiment, likewise as with Embodiments 1 through 4, setting up in the melt a temperature gradient-not being restricted to the orientation in which the Group III nitride crystal grows-in which the temperature lowers from the melt interface with the nitrogen-containing substance through to the melt interface with the seed crystal or with the Group III nitride crystal having grown onto the seed crystal enables promoting growth of the Group III nitride crystal atop the seed crystal.

Likewise, in this embodiment as well growth of the Group III nitride crystal atop the seed crystal can be promoted by: as illustrated in Embodiment 2, utilizing manufacturing equipment in which the heaters 23 and the insulating member 24 are constituted from graphite; as illustrated in Embodiment 3, pretreating the reaction vessel by heating it to remove moisture; and as illustrated in Embodiment 4, removing the surface oxidation layer from the melt.

In addition, in Embodiments 1 through 5 described above, during the melt-formation step flowing an inert gas such as argon into and out of the interior of the outer container to remove oxygen and/or water vapor adhering to the reaction vessel, heaters, and insulating member inside the outer container is advantageous. In this aspect, it is preferable that the flow rate of the inert gas be 1 cm ³/min. or more per 10 cm³ outer container. Likewise, prior to the crystal growth step that follows the melt-formation step, flowing in and out a reducing gas such as hydrogen to deoxidize the surfaces of the reaction vessel, heaters, and insulating member inside the outer container is advantageous. In this aspect, it is preferable that the flow rate of the reducing gas be 1 cm ³/min. or more per 10 cm³ outer container. Adopting such measures enables the dissolution of oxygen and/or water vapor into the melt inside the reaction vessel to be kept further under control, the more to promote growth of the Group III nitride crystal.

### Embodiment 6

In Fig. 4, still another Group III nitride-crystal manufacturing method involving the present invention is represented. With reference to Fig. 4, in the manufacturing equipment utilized in this manufacturing method, at least the reaction vessel 21, heaters 23 (the low-temperature heater 23a and high-temperature heaters 23b and 23c) for heating the reaction vessel, and the insulating member 24 are housed in the outer container 22. In the present case, the embodiment is adapted to an implementation in which a nitrogen-containing substance in solid form, such as NaN₃ or a Group III nitride, is utilized as the material serving as the nitrogen source.

In the present embodiment, in the melt-formation step, the melt 1, which contains the Group III element and a catalyst, is formed inside the reaction vessel 21 around the seed crystal 2 and the solid-form nitrogen-containing substance 3; and in the crystal-growth step, the nitrogen-containing substance 3 is dissolved in the melt to grow Group III nitride crystal onto the seed crystal 2. In this aspect, as a method of forming around the seed crystal 2 and the solid-form nitrogen-containing substance 3 inside the reaction vessel 21 the melt 1 containing a Group III element and a catalyst, although there are no restrictions in particular, from a workability perspective, advantageously the melt 1 containing the Group III element and the catalyst is formed by situating the seed crystal 2 in one end of the reaction vessel 21, situating the nitrogen-containing substance 3 in the other end of the reaction vessel 21, between them entering in the Group III element and the catalyst, and thereafter heating these materials.

In this embodiment, by adjusting the temperatures of the low-temperature-heating heater 23a and the high-temperature-heating heaters 23b and 23c, a temperature gradient that lowers the temperature of the melt 1 from the interface 13 between the melt 1 and the nitrogen-containing substance 3, through to the interface 12 between the melt 1 and the seed crystal 2 or to the interface 14 between the melt 1 and the Group III nitride crystal 4 having grown onto the seed crystal 2 can be formed.

In the Group III nitride-crystal manufacturing method of the present embodiment a Group III nitride obtained by irradiating with a nitrogen plasma the surface of a molten liquid containing a Group III element can be preferably utilized as the nitrogen-containing substance. The Group III nitride powders commonly sold as reagents-being produced by chemically reacting a Group III element, or an oxide of a Group III element, with ammonia-are of low purity and high cost. Highly pure Group III nitride crystal can be obtained at a high crystal growth rate by instead utilizing a Group III nitride produced as just noted. In this respect, the nitrogen plasma is produced by, for example, causing microwaves or high RF pulses to act on nitrogen gas. By irradiating the molten liquid with such nitrogen plasma a highly pure Group III nitride powder can be obtained efficiently at low cost.

In respect of the seed crystal utilized in the foregoing Embodiments 1 through 6, examples, being not particularly restricted, would include SiC crystal substrates, sapphire crystal substrates, substrates being a thin film of a Group III nitride crystal formed onto a sapphire crystal, and Group-III-nitride crystal substrates. From the viewpoint of quickly growing fine-quality Group III nitride crystal, Group-III-nitride crystal substrates are preferable. Additionally from the viewpoint of quickly growing fine-quality Group III nitride crystal, it is further preferable that the dislocation density in the Group-III-nitride crystal substrate utilized as the seed crystal be 5 × 10⁹ dislocations/cm³. Also, in an implementation in which a Group-III-nitride crystal substrate is employed as the seed crystal, because planar GaN crystal will more readily grow at high speed on the (0001) plane (*Ga* face), it is further preferable that the front side of the seed crystal be the (0001) plane.

Additionally in regard to Embodiments 1 through 6, by also adding silicon to the melt, a concentration of silicon within the Group III nitride crystal can be adjusted. By adjusting the concentration of silicon, which in the Group III nitride crystal is a dopant, Group III nitride crystal accorded with objectives can be obtained. For example, Group III nitride crystal in which the silicon concentration surpasses 1 × 10¹⁷ atoms/cm³ has increased electroconductivity and thus is suited to the manufacture of optical devices. By the same token, Group III nitride crystal in which the silicon concentration is 1 × 10¹⁷ atoms/cm³ or less has reduced electroconductivity and thus is suited to the manufacture of electronic devices.

In Embodiments 1 through 6, furthermore, by also adding an oxygen-containing substance to the melt or to the nitrogen-containing substance a concentration of oxygen within the Group III nitride crystal can be adjusted. In this aspect, examples of the oxygen-containing substance, being not particularly restricted as long as they can supply oxygen into the Group III nitride crystal, would include oxygen gas and sodium oxide (Na₂O). By adjusting the concentration of oxygen, which in the Group III nitride crystal is a dopant, Group III nitride crystal accorded with objectives can be obtained. For example, Group III nitride crystal in which the oxygen concentration surpasses 1 × 10¹⁷ atoms/cm³ has increased electroconductivity and thus is suited to the manufacture of optical devices. By the same token, Group III nitride crystal in which the oxygen concentration is 1 × 10¹⁷ atoms/cm³ or less has reduced electroconductivity and thus is suited to the manufacture of electronic devices.

### Implementation Examples

### Example 1

Reference is made to Fig. 1B in the first drawing sheet: A Ga-Na melt surrounding a GaN crystal substrate was formed by setting a GaN crystal substrate as the seed crystal 2 onto a sapphire rod, being the cooling member 42 for the reaction vessel 21, and by introducing, so as to be in a 50 : 50 mol % ratio in the melt, into and heating within the reaction vessel 21 Ga as the Group III element and Na as the catalyst. In forming the melt, the amount of heat from the high-temperature heater 23b and amount of heat from the low-temperature heater 23a were adjusted so that the Ga-N melt would have a temperature gradient in which its surface temperature (equal to *T_{N}*) would be 850°C, and the temperature at the interface between the Ga-N melt and the GaN crystal substrate (equal to *T_{C}*) would be 800°C.

Reference is next made to Fig. 1C: Nitrogen gas as the nitrogen-containing substance 3 was supplied, such that the nitrogen-gas pressure would be 1.0 MPa, to the foregoing Ga-N melt. It should be noted that under these circumstances, in the Ga-N melt the temperature (*T_{O}*) at which GaN crystal deposits is 830°C. By supplying nitrogen gas to the surface of a Ga-N melt having the temperature gradient just described, crystal was grown only onto the GaN crystal substrate that was the seed crystal 2. The crystal growth rate of this crystal was 3.2 µm/hour. The obtained crystal was characterized by XRD (X-ray diffraction), wherein it was confirmed from the lattice constant that the product was a GaN crystal. The results are tabulated in Table I.

### Comparative Example 1

A GaN crystal was grown likewise as in Example 1, except that, without setting up a temperature gradient in the Ga-N melt, the temperature of the Ga-N melt in its entirety was made 800°C. The GaN crystal grew not only onto the GaN crystal substrate that was the seed crystal, but also grew randomly on the surface of the Ga-N melt, and on the interface between the Ga-N melt and the reaction vessel. The results are tabulated in Tables I and IV.

### Examples 2 through 7

Fig. 1 is illustrative of these implementation examples. Utilizing the Group III elements, catalysts, seed crystals, and nitrogen-containing substances set forth in Table I, melts were formed surrounding seed crystals by arranging for the temperature of the surface of each melt 1 (equal to *T_{N}*) and the temperature at the interface between the melt 1 and its seed crystal 2 (*T_{C}*) to be the temperatures indicated in Table I, and then nitrogen gas or else ammonia gas as the nitrogen-containing substance 3 was supplied, such that the gas pressure would be 1.0 MPa, to each melt 1. In every one of Examples 2 through 7, Group III nitride crystal grew onto the seed crystal only. The results are tabulated in Table I. In addition, results for Example 2 are also set forth in Table IV.

### Comparative Example 2

An A1N crystal was grown likewise as in Example 7, except that, without setting up a temperature gradient in the Al-Fe melt, the temperature of the Al-Fe melt in its entirety was rendered 800°C. The results are tabulated in Table I.

### Example 8

Fig. 8 is illustrative of this implementation example. A GaN crystal was grown likewise as in Example 1, other than that the seed crystal 2 was disposed in a side portion of the reaction vessel 21 with the principal, crystal-growing face directed sideways, and the low-temperature heater 23a and high-temperature heater 23b were installed so as to set up a sideways oriented temperature gradient in the melt inside the reaction vessel 21, wherein the Group III nitride crystal 4 was grown in a lateral direction of the seed crystal 2. The results are tabulated in Table I. It should be understood that in the present implementation example, the temperature *T_{N}* at the interface between the nitrogen-containing substance and the melt means the temperature of the region farthest from the seed crystal in the interface between the nitrogen-containing substance and the melt.

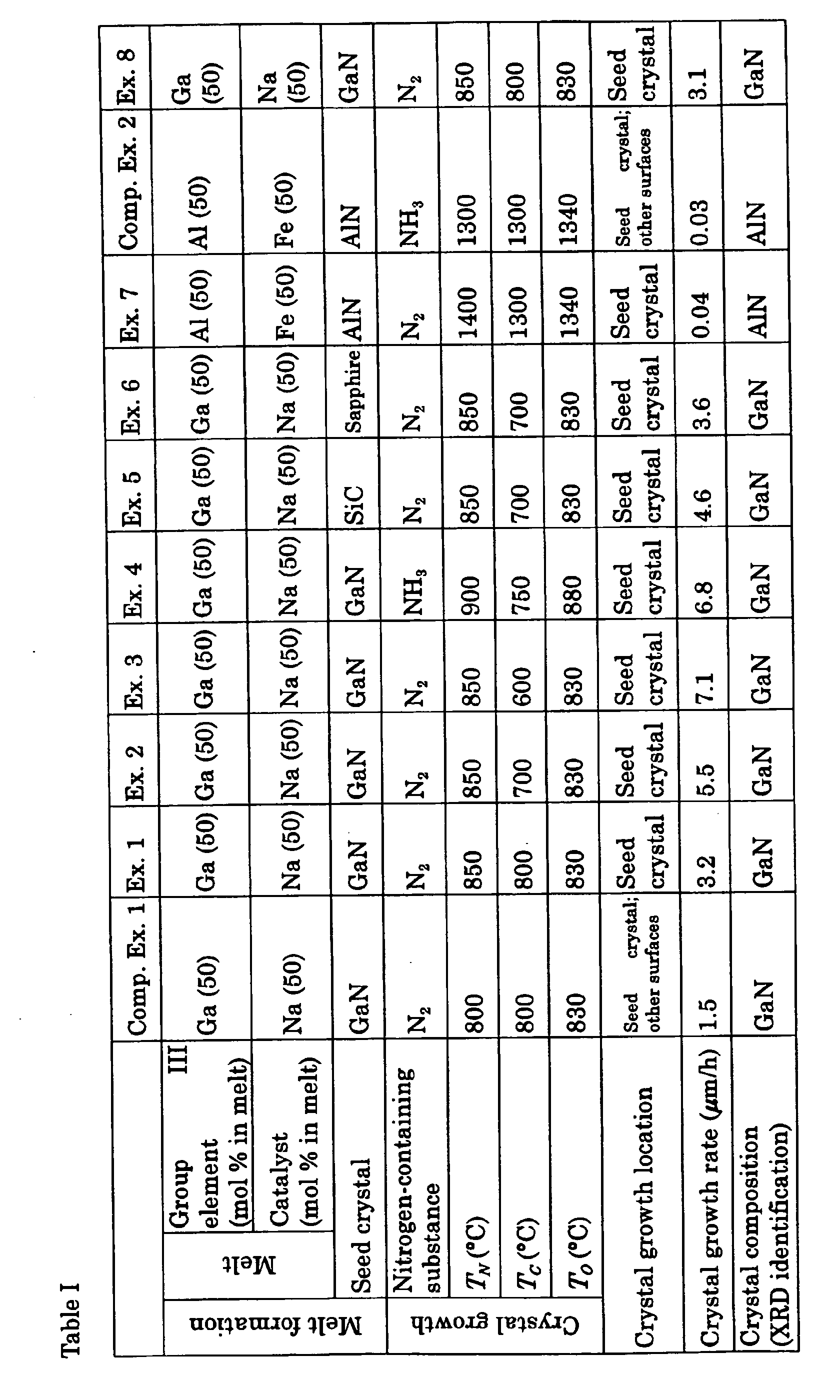

As will be understood from Table I, the crystal growth rate of the GaN crystal in Examples 1 through 3 and in Example 8, in which there was a temperature gradient *T_{N} > T_{C}* in the melt, proved to be greater than the crystal growth rate of the GaN crystal in Comparative Example 1, in which there was no temperature gradient in the melt. It will also be noted that the crystal growth rate grew greater as *T_{N}- T_{C}* became larger. Finally, in terms of not only GaN crystal growth but also A1N crystal growth, by setting up a temperature gradient *T_{N} **>** T_{C}* in the melt the crystal growth rate of the A1N crystal increased (Example 7, Comparative Example 2).

### Examples 9 through 11

Fig. 1 is illustrative of these implementation examples. Melts containing a dopant were formed around seed crystals by introducing into and heating within the reaction vessel Ga as the Group III element, Na as the catalyst, Si or Na₂O (sodium oxide) as the dopant, and GaN crystal substrates as the seed crystals, as set forth in Table II. In forming the melt, the amount of heat from the heating heaters was adjusted so that the surface temperature of each melt 1 (equal to *T_{N}*) would be 850°C, and the temperature at the interface between each melt 1 and crystal substrate 2 (*T_{C}*) would be 700°C. Subsequently, nitrogen gas as the nitrogen-containing substance 3 was supplied, such that the gas pressure would be 1.0 MPa, to each melt 1. In every one of Examples 9 through 11, GaN crystal incorporating silicon or else oxygen grew onto the seed crystal alone. The results are tabulated in Table II. In these examples the concentration of silicon or oxygen in the GaN crystal was assayed by SIMS (secondary ion mass spectrometry).

### Example 12

Fig. 1 is illustrative of this implementation example. A melt was formed around a seed crystal by introducing into and heating within the reaction vessel Ga as the Group III element, Na as the catalyst, and GaN as the seed crystal, as set forth in Table II. In forming the melt, the amount of heat from the heating heaters was adjusted so that the surface temperature of the melt 1 (equal to *T_{N}*) would be 850°C, and the temperature at the interface between the melt 1 and crystal substrate 2 (*T_{C}*) would be 700°C. Subsequently, a gas mixture of nitrogen gas as a nitrogen-containing substance and oxygen gas as a dopant (ratio between the N₂ mol % and O₂ mol % in the gas mixture was 99.9 : 0.1) were supplied, such that the gas pressure would be 1.0 MPa, to the melt, wherein GaN crystal incorporating oxygen grew onto the seed crystal alone. The results are tabulated in Table II.

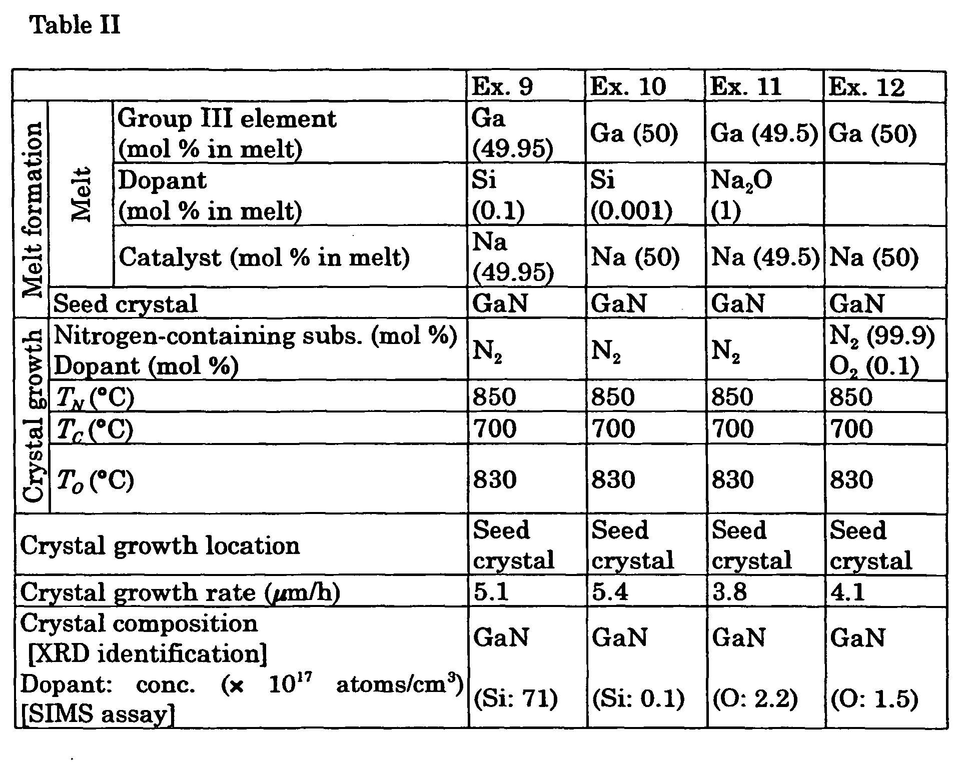

As will be understood from Table II, by adding a dopant to the melt or to the nitrogen-containing substance a Group III nitride crystal having a desired dopant concentration can be obtained.

### Examples 13 through 15

Fig. 4 is illustrative of these implementation examples. Ga-Na melts surrounding GaN crystal substrates that were the seed crystals were formed by setting a GaN crystal substrate as each seed crystal 2 onto a sapphire rod, being the cooling member 42 for the reaction vessel 21, and by introducing into the reaction vessel 50 mol % Ga as a Group III element, 50 mol % Na as a catalyst, and a powder of a Group III nitride as the nitrogen-containing substance 3 in an amount such that the mole ratio with respect to the Group III element would be 1, and heating the ingredients accommodated in the reaction vessel. In forming the melt, the amount of heat from the high-temperature heaters 23b and 23c, and amount of heat from the low-temperature heater 23a were adjusted so that the Ga-N melt would have a temperature gradient in which the temperature at the interface between the Ga-N melt and the powdered Group III nitride (equal to *T_{N}*), and the temperature at the interface between the Ga-N melt and the GaN crystal substrate (equal to *T_{C}*) would be the temperatures as set forth in Table III. As dissolution into the melt of the powdered Group III nitride progressed, GaN crystal grew onto the seed crystal. Herein, utilized for the Group III nitride powder in Examples 13 through 15 was a GaN powder obtained by irradiating a 1000°C Ga molten liquid with a nitrogen plasma produced by causing microwaves of 2.45 GHz frequency and 250 W output power to act on nitrogen gas. The results are tabulated in Table III.

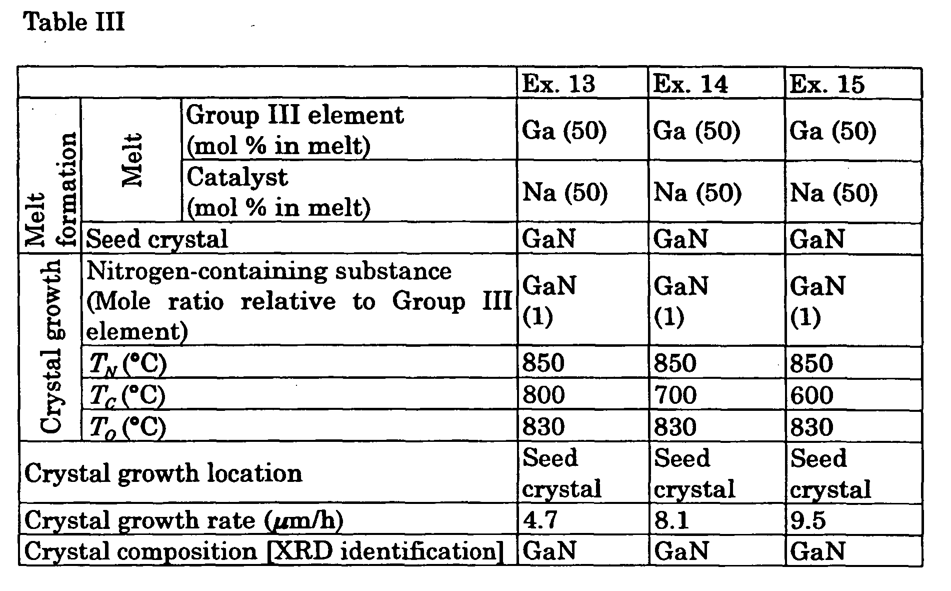

As will be understood from Table III, also in implementations in which a Group III nitride was utilized as the nitrogen-containing substance for supplying nitrogen to the melt, by providing in the melt a *T_{N} **>** T_{C}* temperature gradient likewise as with Examples 1 through 3, the crystal growth rate of the Group III nitride crystal became greater.

### Example 16

Fig. 1 is illustrative of this implementation example. After pretreating the reaction vessel 21 by pumping it down to 100 Pa with a vacuum pump 33 as indicated in Fig. 1A and heating the vessel at 100°C for 1 hour to remove moisture, a Ga-Na melt surrounding a GaN crystal substrate as represented in Fig. 1B was formed by setting a GaN crystal substrate as the seed crystal 2 onto a sapphire rod, being the cooling member 42 for the reaction vessel 21 interior, and by introducing, at the mole percentages in Table III, into and heating within the reaction vessel 21-from which moisture had been removed-Ga as the Group III element and Na as the catalyst. In forming the melt, the amount of heat from the high-temperature heater 23b and amount of heat from the low-temperature heater 23a were adjusted so that the Ga-N melt would have a temperature gradient in which the surface temperature (equal to *T_{N}*) would be 850°C, and the temperature at the interface between the Ga-N melt and the GaN crystal substrate (equal to *T_{C}*) would be 700°C. Next, nitrogen gas as the nitrogen-containing substance 3 as indicated in Fig. 1C was supplied to the Ga-N melt to grow a GaN crystal onto the seed crystal 2. The results are tabulated in Table IV.

### Example 17

Fig. 2 is illustrative of this implementation example. A Ga-Na melt as represented in Fig. 2A, having a temperature gradient similar to that of Example 16, was formed surrounding a GaN crystal substrate by setting a GaN crystal substrate as the seed crystal 2 onto a sapphire rod, being the cooling member 42 for the reaction vessel 21 interior, and by introducing, at the mole percentages in Table III, into and heating within the reaction vessel 21 Ga as the Group III element and Na as the catalyst. Next, as progressing from Fig. 2A to 2B indicates, from the surface of the Ga-Na melt a layer to a depth of up to 10 % with respect to the height of the melt was removed by aspiration, thereby ridding the Ga-Na melt of the surface oxidation layer 11. Subsequently, nitrogen gas as the nitrogen-containing substance 3 as indicated in Fig. 2C was supplied to the Ga-N melt to grow a GaN crystal onto the seed crystal 2. The results are tabulated in Table IV

### Example 18

After pretreating the reaction vessel 21 by heating it at 100°C for 1 hour to eliminate moisture from the vessel, a GaN crystal was grown in the same way as in Example 17. The results are tabulated in Table IV.

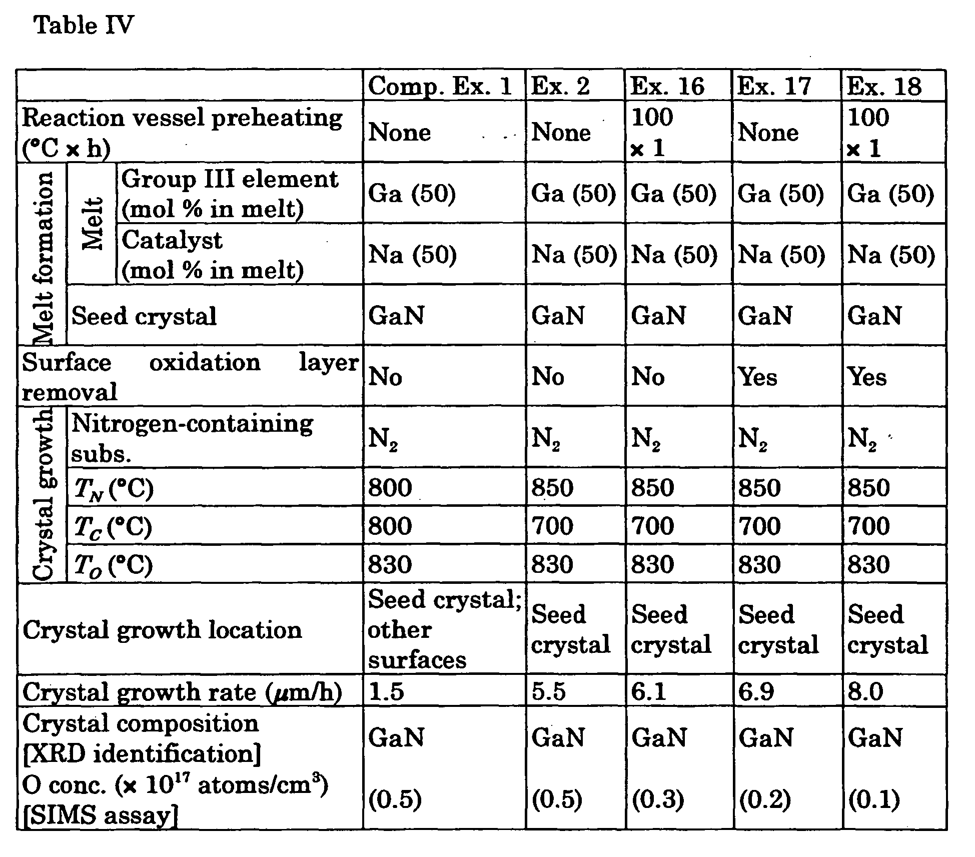

In Table IV, from a comparison between Example 2 and Examples 16 through 18, it is evident that by heating the reaction vessel in advance to rid it of moisture prior to the melt-formation step or, following the melt-formation step, by removing the surface oxidation layer on the melt prior to the crystal-growth step-in either case, as a means to prevent oxidation of the melt-the crystal-growth rate of the GaN crystal increases. It will also be understood that GaN crystals whose oxygen concentration within the crystal was under 1 × 10¹⁷ atoms/cm³ were obtained.

### Examples 19 through 22

Figs. 1 and 2 are illustrative of these examples. Crystal growth to produce GaN crystals was carried out in implementations in which, as indicated in Table V, at least one means to prevent oxidation of the melts-either preliminary heating of the reaction vessel prior to the melt-formation step, or post-melt-formation-step/pre-crystal-growth-step removal of the melt-surface oxidation layer-was provided and a temperature gradient was set up in the melts, and in which various dopants were added to the melt or to the nitrogen-containing substance. The results are tabulated in Table V.

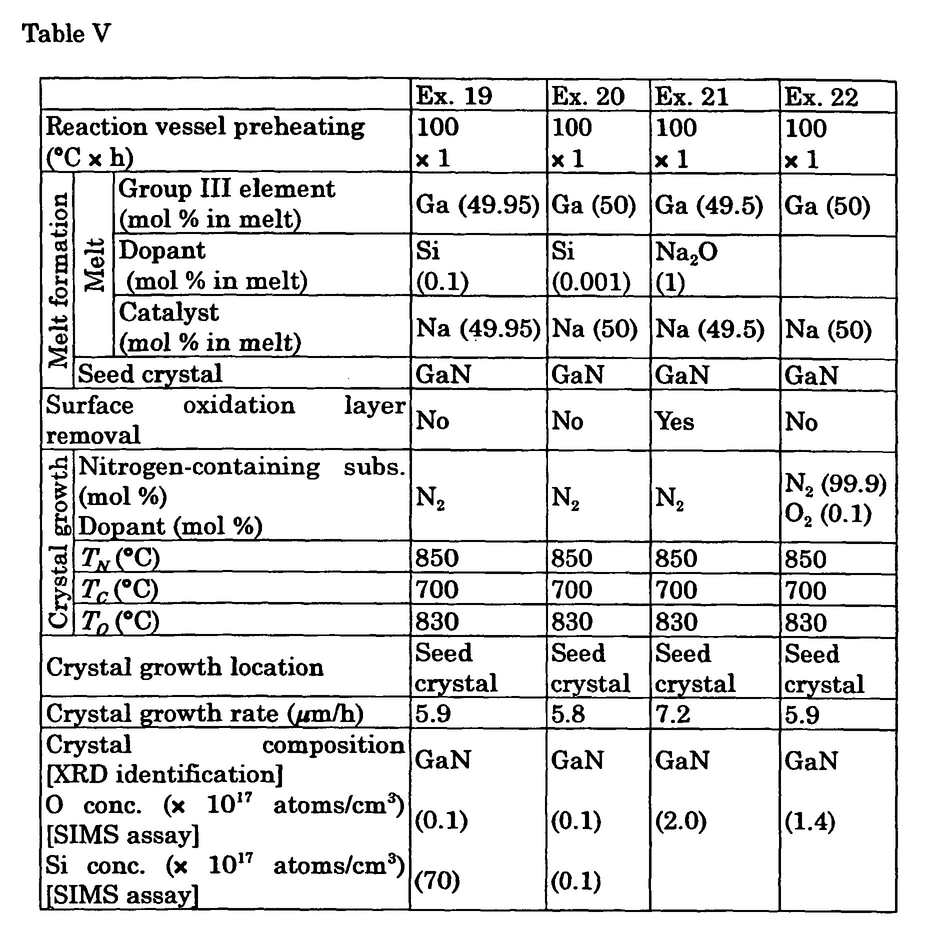

As will be understood from Table V, also in implementations provided with measures to prevent oxidation of the melts and in which a temperature gradient was set up in the melts, by adding a dopant to the melt or the nitrogen-containing substance, GaN crystal having a desired dopant concentration could be obtained.

It should be understood that in the foregoing Implementation Examples 1 through 22, and in Comparative Examples 1 and 2, the reaction vessel utilized was made of pyrolytic BN and the outer container was of stainless steel, while the heater and insulating member utilized were made of graphite (impurity concentration not more than 10 ppm).

The present invention finds broad applicability in Group III nitride crystals and methods of their manufacture, wherein the crystal growth rate is extensive, and in equipment for manufacturing such Group III nitride crystals.

The presently disclosed embodiments and implementation examples should in all respects be considered to be illustrative and not limiting. The scope of the present invention is set forth not by the foregoing description but by the scope of the patent claims, and is intended to include meanings equivalent to the scope of the patent claims and all modifications within the scope.

## Claims

1. A method of manufacturing Group III nitride crystal, including a melt-formation step, within a reaction vessel, of forming around a seed crystal a melt containing at least a Group III element and a catalyst, and a crystal-growth step of supplying a nitrogen-containing substance to the melt to grow a Group III nitride crystal onto the seed crystal,
**characterized by**
controlling the temperature in the crystal-growth step so that the temperature of the melt lowers from the interface between the melt and the nitrogen-containing substance, through to the interface between the melt and the seed crystal or to the interface between the melt and the Group III nitride crystal having grown onto the seed crystal such that the relationship among the temperature T_{N} at the interface between the melt and the nitrogen-containing substance, the temperature T_{C} at the interface between the melt and the seed crystal or at the interface between the melt and the Group III nitride crystal having grown onto the seed crystal, and the temperature T_{O} at which the nitrogen-containing substance having dissolved within the melt deposits as the Group III nitride crystal will be T_{N} > T_{O} ≥ T_{C}, and so that between T_{N} and T_{C} the difference in temperature T_{N} - T_{C} will be from 10°C to 300°C.

2. A Group-III-nitride-crystal manufacturing method as set forth in claim 1, **characterized** furthermore in locally cooling the seed crystal in the crystal-growth step.

3. A Group-III-nitride-crystal manufacturing method as set forth in claim 1 or 2, **characterized in that** graphite is utilized for a heater and an insulating member provided together with the reaction vessel in an outer container.

4. A Group-III-nitride-crystal manufacturing method as set forth in claim 1 or 2, further including a step of pretreating the reaction vessel by heating it to remove moisture from the vessel.

5. A Group-III-nitride-crystal manufacturing method as set forth in any of claims 1 through 4, further including a step, following the melt-formation step, of removing a surface-oxidation layer from the melt prior to the crystal-growth step.

6. A Group-III-nitride-crystal manufacturing method as set forth in any of claims 1 through 5, wherein a Group-III-nitride-crystal substrate is utilized as the seed crystal.

7. A Group-III-nitride-crystal manufacturing method as set forth in any of claims 1 through 6, wherein the melt-formation step is a step of forming around both the seed crystal and a nitrogen-containing substance within the reaction vessel a melt containing at least a Group III element and a catalyst; and the crystal-growth step is a step in which by the nitrogen-containing substance dissolving in the melt the Group III nitride crystal is grown onto the seed crystal.

8. A Group-III-nitride-crystal manufacturing method as set forth in any of claims 1 through 7, wherein the nitrogen-containing substance is a Group III nitride obtained by irradiating with a nitrogen plasma the surface of a molten liquid containing at least a Group III element.

9. A Group-III-nitride-crystal manufacturing method as set forth in any of claims 1 through 7, wherein by furthermore adding silicon as a dopant to the melt, a concentration of silicon within the Group III nitride crystal is adjusted.

10. A Group-III-nitride-crystal manufacturing method as set forth in any of claims 1 through 7, wherein by furthermore adding an oxygen-containing substance as a dopant either to the melt or to the nitrogen-containing substance, a concentration of oxygen within the Group III nitride crystal is adjusted.

11. Group-III-nitride-crystal manufacturing equipment comprising:
a reaction vessel (21) that can accommodate around a seed crystal (2) a melt (1) containing at least a Group III element and a catalyst; and
a cooling member (42) for locally cooling the seed crystal,
**characterized by** further comprising:
a low-temperature heater 23a and a high-temperature heater 23b surrounding the reaction vessel (21) such that the temperature of the melt lowers from the interface between the melt and a nitrogen-containing substance, through to the interface between the melt and the seed crystal or the interface between the melt and the Group III nitride crystal having grown onto the seed crystal.

## Patentansprüche

1. Verfahren zum Herstellen von Nitridkristall der Gruppe III, das einen Schmelzeerzeugungsschritt in einem Reaktionsgefäß zum Ausbilden einer Schmelze, die wenigstens ein Element der Gruppe III und einen Katalysator enthält, um einen Keimkristall herum sowie einen Kristallzüchtungsschritt zum Zuführen einer stickstoffhaltigen Substanz zu der Schmelze einschließt, um einen Nitridkristall der Gruppe III auf dem Keimkristall zu züchten,
**gekennzeichnet durch**
Steuern der Temperatur in dem Kristallzüchtungsschritt so, dass die Temperatur der Schmelze von der Grenzfläche zwischen der Schmelze und der stickstoffhaltigen Substanz bis zu der Grenzfläche zwischen der Schmelze und dem Keimkristall oder zu der Grenzfläche zwischen der Schmelze und dem Nitridkristall der Gruppe III, der auf dem Keimkristall gezüchtet worden ist, so abnimmt, dass die Beziehung zwischen der Temperatur T_{N} an der Grenzfläche zwischen der Schmelze und der stoffstoffhaltigen Substanz, der Temperatur T_{C} an der Grenzfläche zwischen der Schmelze und dem Keimkristall oder an der Grenzfläche zwischen der Schmelze und dem Nitridkristall der Gruppe III, der auf dem Keimkristall gezüchtet worden ist, und der Temperatur T_{O}, bei der die stickstoffhaltige Substanz, die sich in der Schmelze aufgelöst hat, als der Nitridkristall der Gruppe III abgeschieden wird, T_{N} > T_{O} ≥ T_{C} ist, und so, dass die Temperaturdifferenz T_{N} - T_{C} zwischen T_{N} und Tc die Temperaturdifferenz T_{N} - T_{C} zwischen 10 °C und 300 °C liegt.

2. Verfahren zum Herstellen eines Nitridkristalls der Gruppe III nach Anspruch 1, **gekennzeichnet** des Weiteren durch lokales Kühlen des Keimkristalls bei dem Kristallzüchtungsschritt.

3. Verfahren zum Herstellen eines Nitridkristalls der Gruppe III nach Anspruch 1 oder 2, **dadurch gekennzeichnet, dass** Graphit als ein Heizmittel und ein Isolierelement eingesetzt wird, das zusammen mit dem Reaktionsgefäß in einem äußeren Behälter vorhanden ist.

4. Verfahren zum Herstellen eines Nitridkristalls der Gruppe III nach Anspruch 1 oder 2, das des Weiteren einen Schritt des Vorbehandeins der Reaktionsgefäßes durch Erhitzen desselben einschließt, um Feuchtigkeit aus dem Gefäß zu entfernen.

5. Verfahren zum Herstellen eines Nitridkristalls der Gruppe III nach einem der Ansprüche 1 bis 4, das des Weiteren nach dem Schmelzeerzeugungsschritt einen Schritt des Entfernens einer Oberflächenoxidationsschicht von der Schmelze vor dem Kristallzüchtungsschritt einschließt.

6. Verfahren zum Herstellen eines Nitridkristalls der Gruppe III nach einem der Ansprüche 1 bis 5, wobei ein Nitridkristallsubstrat der Gruppe III als der Keimkristall eingesetzt wird.

7. Verfahren zum Herstellen eines Nitridkristalls der Gruppe III nach einem der Ansprüche 1 bis 6, wobei der Schmelzeerzeugungsschritt ein Schritt des Erzeugens einer Schmelze, die wenigstens ein Element der Gruppe III und einen Katalysator enthält, sowohl um den Keimkristall als auch eine stickstoffhaltige Substanz in dem Reaktionsgefäß ist und der Kristallzüchtungsschritt ein Schritt ist, in dem durch die sich in der Schmelze auflösende stickstoffhaltige Substanz der Nitridkristall der Gruppe III auf dem Keimkristall gezüchtet wird.

8. Verfahren zum Herstellen eines Nitridkristalls der Gruppe III nach einem der Ansprüche 1 bis 7, wobei die stickstoffhaltige Substanz ein Nitrid der Gruppe III ist, das gewonnen wird, indem die Oberfläche einer geschmolzenen Flüssigkeit, die wenigstens ein Element der Gruppe III enthält, mit einem Stickstoffplasma bestrahlt wird.

9. Verfahren zum Herstellen eines Nitridkristalls der Gruppe III nach einem der Ansprüche 1 bis 7, wobei des Weiteren, indem Silizium als ein Dotierstoff zu der Schmelze hinzugefügt wird, eine Konzentration von Silizium in dem Nitridkristall der Gruppe III reguliert wird.

10. Verfahren zum Herstellen eines Nitridkristalls der Gruppe III nach einem der Ansprüche 1 bis 7, wobei, indem des Weiteren eine sauerstoffhaltige Substanz als ein Dotierstoff entweder zu der Schmelze oder zu der stickstoffhaltigen Substanz hinzugefügt wird, eine Konzentration von Sauerstoff in dem Nitridkristall der Gruppe III reguliert wird.

11. Einrichtung zum Herstellen von Nitridkristall der Gruppe III, die umfasst:
ein Reaktionsgefäß (21), das um einen Keimkristall (2) herum eine Schmelze (1) aufnehmen kann, die wenigstens ein Element der Gruppe III und einen Katalysator enthält; und
ein Kühlelement (42) zum lokalen Kühlen des Keimkristalls,
**dadurch gekennzeichnet, dass** sie des Weiteren umfasst:
eine Niedrigtemperatur-Heizeinrichtung (23a) und eine Hochtemperatur-Heizeinrichtung (23b), die das Reaktionsgefäß (21) so umgeben, dass die Temperatur der Schmelze von der Grenzfläche zwischen der Schmelze und einer stickstoffhaltigen Substanz, bis zu der Grenzfläche zwischen der Schmelze und dem Keimkristall oder der Grenzfläche zwischen der Schmelze und dem Nitridkristall der Gruppe III, der auf dem Keimkristall gezüchtet worden ist, abnimmt.

## Revendications

1. Procédé de fabrication d'un cristal de nitrure du groupe III, comprenant une étape de formation en fusion, à l'intérieur d'un récipient de réaction, consistant à former autour d'un germe de cristallisation une masse fondue contenant au moins un élément du groupe III et un catalyseur, et une étape de croissance du cristal consistant à apporter une substance contenant de l'azote à la masse fondue pour faire croître un cristal de nitrure du groupe III sur le germe de cristallisation, **caractérisé en ce que**
la température dans l'étape de croissance du cristal est commandée de telle sorte que la température de la masse fondue diminue de l'interface entre la masse fondue et la substance contenant de l'azote jusqu'à l'interface entre la masse fondue et le germe de cristallisation ou jusqu'à l'interface entre la masse fondue et le cristal de nitrure du groupe III ayant crû sur le germe de cristallisation de telle sorte que la relation entre la température T_{N} à l'interface entre la masse fondue et la substance contenant de l'azote, la température T_{C} à l'interface entre la masse fondue et le germe de cristallisation ou à l'interface entre la masse fondue et le cristal de nitrure du groupe III ayant crû sur le germe de cristallisation et la température T_{O} à laquelle la substance contenant de l'azote s'étant dissoute à l'intérieur des dépôts de masse fondue en tant que cristal de nitrure du groupe III sera T_{N} > T_{O} ≥ T_{C}, et **en ce que** entre T_{N} et T_{C}, la différence de température T_{N} - T_{C} sera de 10°c à 300°C.

2. Procédé de fabrication d'un cristal de nitrure du groupe III selon la revendication 1, **caractérisé en outre par** le refroidissement local du germe de cristallisation dans l'étape de croissance du cristal.

3. Procédé de fabrication d'un cristal de nitrure du groupe III selon la revendication 1 ou 2, **caractérisé en ce que** du graphite est utilisé pour un élément de chauffage et un élément isolant fournis avec le récipient de réaction dans un contenant externe.

4. Procédé de fabrication d'un cristal de nitrure du groupe III selon la revendication 1 ou 2, comprenant en outre une étape de prétraitement du récipient de réaction par chauffage de celui-ci pour chasser l'humidité du récipient.

5. Procédé de fabrication d'un cristal de nitrure du groupe III selon l'une quelconque des revendications 1 à 4, comprenant en outre une étape, après l'étape de formation en fusion, consistant à enlever une couche d'oxydation superficielle de la masse fondue avant l'étape de croissance du cristal.

6. Procédé de fabrication d'un cristal de nitrure du groupe III selon l'une quelconque des revendications 1 à 5, où on utilise un substrat de cristal de nitrure du groupe III comme germe de cristallisation.

7. Procédé de fabrication d'un cristal de nitrure du groupe III selon l'une quelconque des revendications 1 à 6, où l'étape de formation en fusion est une étape de formation, autour du germe de cristallisation et d'une substance contenant de l'azote à l'intérieur du récipient de réaction, d'une masse fondue contenant au moins un élément du groupe III et un catalyseur ; et l'étape de croissance du cristal est une étape dans laquelle la dissolution de la substance contenant de l'azote dans la masse fondue provoque la croissance du cristal de nitrure de groupe III sur le germe de cristallisation.

8. Procédé de fabrication d'un cristal de nitrure du groupe III selon l'une quelconque des revendications 1 à 7, où la substance contenant de l'azote est un nitrure du groupe III obtenu par irradiation, au moyen d'un plasma à l'azote, de la surface d'un liquide fondu contenant au moins un élément du groupe III.

9. Procédé de fabrication d'un cristal de nitrure du groupe III selon l'une quelconque des revendications 1 à 7, où, en ajoutant en outre du silicium comme dopant à la masse fondue, on ajuste une concentration de silicium à l'intérieur du cristal de nitrure du groupe III.

10. Procédé de fabrication d'un cristal de nitrure du groupe III selon l'une quelconque des revendications 1 à 7, où, en ajoutant en outre une substance contenant de l'oxygène en tant que dopant soit à la masse fondue, soit à la substance contenant de l'azote, on ajuste une concentration d'oxygène à l'intérieur du cristal de nitrure du groupe III.

11. Equipement de fabrication d'un cristal de nitrure du groupe III comprenant :
un récipient de réaction (21) qui peut loger autour du germe de cristallisation (2) une masse fondue (1) contenant au moins un élément du groupe III et un catalyseur ; et
un élément refroidissant (42) pour refroidir localement le germe de cristallisation,
**caractérisé en ce qu'**il comprend en outre :
un élément de chauffage basse température (23a) et un élément de chauffage haute température (23b) entourant le récipient de réaction (21) de telle sorte que la température de la masse fondue diminue de l'interface entre la masse fondue et une substance contenant de l'azote jusqu'à l'interface entre la masse fondue et le germe de cristallisation ou l'interface entre la masse fondue et le cristal de nitrure du groupe III ayant crû sur le germe de cristallisation.
